# FASCICULE DE BREVET EUROPEEN

(11) **EP 2 232 204 B1**
(45) Date de publication et mention de la délivrance du brevet: **12.10.2011**
(21) Numéro de dépôt: 08864065.1
(22) Date de dépôt: 11.12.2008
(51) Int. Cl.: G01D 4/02, G01R 11/24, G01R 35/04

(54) **COMPTEUR MODULAIRE DE CONSOMMATION D'EFFLUENT**
MODULARER ABGASVERBRAUCHMESSER
EFFLUENT CONSUMPTION MODULAR METER

(30) Priorité: 12.12.2007 FR 0708661
(43) Date de publication de la demande: 29.09.2010
(60) Demande divisionnaire: 10188414.6
(73) Titulaire: Electricité de France, 75008 Paris (FR)
(72) Inventeur: MOULARD, Jean-Michel, F-78860 Saint Nom La Breteche (FR)
(74) Mandataire: Cabinet Plasseraud
(86) Numéro de dépôt international: PCT/FR2008/052284
(87) Numéro de publication internationale: WO 2009/081001

(56) Documents cités:
- EP-A- 0 598 521
- EP-A- 0 715 171
- WO-A-94/19899
- US-A- 4 571 691
- US-A- 5 870 911
- US-A1- 2005 194 962

## Description

L'invention concerne les compteurs de consommation d'effluent, la notion d'effluent recouvrant les effluents domestiques et/ou industriels.

Parmi les effluents précités, ceux-ci sont constitués, notamment, par l'eau, le gaz et l'électricité pour ce qui concerne les effluents domestiques, auxquels il faut ajouter les carburants, et les gaz industriels pour les effluents industriels.

A l'heure actuelle, la modernisation et la fiabilisation des systèmes de comptage est un axe de recherche et développement majeur dans tous les pays industrialisés.

En particulier, un objectif essentiel des travaux correspondants concerne la mise en place de nouveaux services directement liés au comptage, et, par extension, aux économies d'énergie.

En outre, les nouveaux services précités ont pour principal objectif de diminuer les interventions chez les abonnés clients, grâce à la mise en place d'une gestion et d'une exploitation centralisées de chaque compteur d'effluent.

En France, par exemple, la seule distribution d'un effluent tel que l'électricité concerne sensiblement 34 millions de points de comptage.

Une telle gestion et exploitation centralisées ont en outre pour objectif connexe la rationalisation et la généralisation d'outils antifraude, eux-mêmes contrôlés de manière centralisée, afin de réduire à un strict minimum les interventions physiques sur chaque point de comptage, le nombre de type d'intervention physique pouvant ainsi être réduit à un seul, le changement pur et simple des seuls éléments de comptage.

Les compteurs d'effluent actuels les plus élaborés, ceux notamment mis en oeuvre pour le comptage de la distribution d'énergie électrique, sont des compteurs électroniques constitués de tout ou partie des organes ci-après :
- capteur de tension, capteur d'intensité, organe de coupure, circuits de pré-traitement métrologique, traitement, alimentation, afficheur, interface de télécommunication, clavier ou boutons poussoirs, interface de capteur extérieur.

En particulier, les interfaces de communication sont reliées au réseau téléphonique commuté, RTC, au réseau à fibre optique, au réseau radio, au réseau CPL (Courants Porteurs en Ligne) ou autre, en fonction des disponibilités de ces réseaux.

La demande EP-A-0598521 décrit par exemple un compteur électrique se composant d'un module de base, permettant la mesure de l'énergie électrique consommée, associé à deux modules complémentaires comprenant respectivement un modem et un interrupteur de puissance.

Cependant, outre le fait que l'ensemble des composants électriques exécutant des fonctions non intelligentes à caractère permanent ne soit pas séparé de l'ensemble des composants électroniques exécutant des fonctions intelligentes à caractère évolutif dans deux modules distincts, les différents modules complémentaires de ce compteur peuvent être désolidarisés facilement du module de base, ce qui rend un tel compteur sensible à des tentatives de manipulation frauduleuse.

Dans le domaine du comptage d'énergie électrique, il existe deux familles de compteurs, les compteurs industriels, dans lesquels les variables physiques tension et intensité sont mesurées à l'aide de capteurs extérieurs aux compteurs et les compteurs domestiques où les capteurs correspondants sont placés à l'intérieur du compteur, l'intensité électrique consommée par l'abonné client transitant en totalité dans le compteur.

Pour les compteurs domestiques, puissance souscrite en triphasé en France inférieur à 36 kVA, les contraintes d'échauffement sont en conséquence plus importantes. En effet, l'arrivée du câble via le réseau de distribution électrique, en amont du compteur, et la sortie du câble vers l'installation du client, en aval du compteur, sont raccordées directement sur les circuits du compteur.

Des borniers à vis garantissent le maintien mécanique et la continuité électrique.

Une version dérivée du compteur domestique est apparue plus récemment, sous forme d'un compteur embrochable.

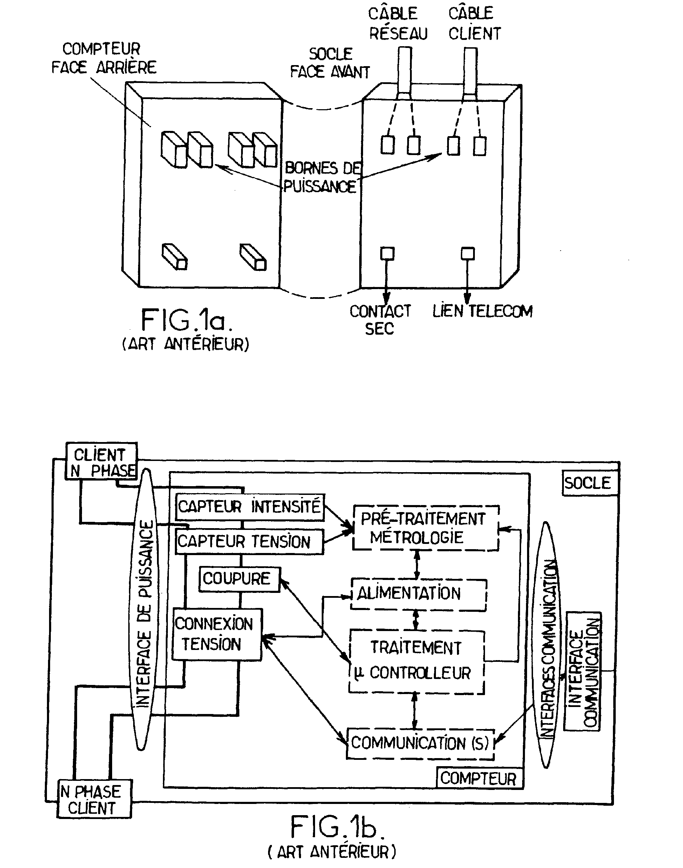

Ce type de compteur est constitué de deux parties, un socle intégrant toute la connectique avec les câbles de puissance et les liens de communication et une partie compteur équipée d'interfaces de puissance et de communication spécifiques pour être raccordées sur le socle par une broche de puissance. La partie précitée possède tous les autres organes du compteur, soit les capteurs, le composant de calcul de l'énergie, l'afficheur, etc.... Un tel type de compteur est représenté en figure 1a.

Le compteur embrochable permet de changer la partie compteur sans intervention sur les câbles réseaux et les câbles clients.

Toutefois, la totalité de l'énergie électrique mesurée par la partie compteur transite dans cette dernière, comme dans le cas du compteur électronique classique.

Les fonctions exécutées par la partie compteur du compteur embrochable sont représentées en figure 1b.

Bien que les compteurs embrochables permettent une homogénéisation des points de distribution de l'effluent électrique grâce à la mise en oeuvre d'un seul type de socle, permettant des gains en maintenance et en logistique appréciables et d'éviter la manipulation fréquente des câbles en minimisant les risques d'échauffement, le socle étant placé une fois pour toutes, la partie embrochable est toutefois le siège d'inconvénients réels.

Un premier inconvénient réside dans le dimensionnement des plots de la partie embrochable, lequel doit être en mesure de faire transiter la puissance maximale souscrite par le client abonné. L'acheminement d'intensités de courant électrique pouvant atteindre 90A impose la mise en oeuvre d'un système de contact au niveau du socle permettant de pincer suffisamment les fiches du compteur. Plus ce pincement est important, plus l'action mécanique, usure par frottement, d'embrochage ou de débrochage manuel est importante. Cette contrainte impose une conception mécanique durcie, notamment dans le cas du compteur triphasé dans lequel le nombre d'entrées et de sorties de puissances est doublé. Les spécifications mécaniques précitées au niveau des broches sont coûteuses et interdisent l'installation de ce type de compteur sur des platines de compteurs existantes, non adaptées à cet effet.

Un deuxième inconvénient concerne la sécurité. Le compteur embrochable ECEBI utilisé en France doit être équipé d'un dispositif de détection et d'inhibition d'un débrochage de la partie compteur par un tiers non habilité, car les risques d'électrocution ne sont pas négligeables. Cette fonction est actuellement exécutée par une simple vis à scellé.

L'expérience a montré, sur le territoire français, que la cause principale de panne des compteurs électroniques classiques et des compteurs embrochables est la défaillance des composants électroniques. Dans 80% des cas, les composants, notamment ceux de l'alimentation, de l'afficheur et des composants de protection sont concernés.

Enfin, la demande de brevet US 2004/070 517 décrit un compteur électronique d'énergie électrique, dans lequel une subdivision des circuits entre circuits de puissance et circuits susceptibles d'être changés est proposée. Toutefois, l'ensemble de ces derniers est intégré dans un boîtier unique.

La présente invention a pour objet de remédier aux inconvénients précités, mis en évidence pour les compteurs électroniques classiques et embrochables d'énergie électrique, ou plus généralement d'effluent.

Un autre objet de la présente invention est la mise en oeuvre d'un nouveau type de compteur, compteur modulaire, autorisant la mise en oeuvre d'une large variété de services liés au comptage, notamment, de manière non limitative : commande à distance de
- la lecture des index de comptage à distance, via un réseau de communication ;
- la programmation des nouveaux tarifs dans le compteur ;
- la modification des paramètres du compteur ;
- l'interruption de la fourniture d'énergie ;
- du relevé des informations ;
- de la gestion de la sécurité des transactions entre chaque compteur et un point de gestion et d'exploitation centralisé ;
- de la gestion des sécurités antifraude.

Le compteur modulaire de consommation d'effluent par un abonné client, objet de l'invention, est remarquable en ce qu'il comprend au moins :
- un module socle permettant d'adapter la configuration de connexion du point de livraison d'effluent, pour assurer la liaison des canalisations du réseau de distribution d'effluent et les canalisations d'alimentation de l'installation d'abonné, ledit module socle étant équipé d'une interface de connexion de comptage et comprenant au moins un organe de coupure ;
- un module de comptage installé par enfichage sur ledit module socle et équipé d'une interface de connexion audit module socle, par l'intermédiaire de ladite interface de connexion de comptage;
- une vis de fixation du module de comptage sur le module socle ;
   dans lequel ledit module de comptage comporte en outre des ressources anti-fraude comportant au moins une vis à scellé d'accès à la vis de fixation et des moyens de détection d'un accès non autorisé à ladite vis de fixation à scellé, permettant de commander, dans ledit module socle, ledit au moins un organes de coupure ;
   dans lequel l'ensemble des composants électriques exécutant les fonctions non intelligentes à caractère permanent est installé dans ledit module socle et ce que l'ensemble des composants électroniques exécutant des fonctions intelligentes à caractère évolutif est installé dans ledit module de comptage.

Selon un mode de réalisation avantageux, les ressources anti-fraude comportent en outre des moyens de détection d'une dépose du module de comptage non autorisée.

Selon un autre mode de réalisation avantageux, les ressources anti-fraude incluent en outre des moyens de détection d'une substitution du module de comptage non autorisée.

Ce compteur modulaire objet de l'invention trouve application non seulement aux compteurs d'énergie électrique, mais, plus généralement, aux compteurs d'effluents les plus usuels.

Il sera mieux compris à la lecture de la description et à l'observation des dessins ci-après dans lesquels, outre les figures 1a et 1b relatives à l'art antérieur,
- la figure 2a représente, à titre illustratif, un compteur modulaire conforme à l'objet de la présente invention ;
- les figures 2b et 2c représentent, à titre illustratif, la répartition des fonctionnalités entre le module socle et le module de comptage, selon une premier et un deuxième exemple, respectivement ;
- la figure 3a représente, à titre illustratif, un exemple non limitatif du module socle pour un compteur mono- et/ou tri-phasé ;
- la figure 3b représente, à titre illustratif, une implémentation des composants du module socle pour un compteur monophasé ;
- la figure 3c représente, à titre illustratif, une implémentation des composants du module socle pour un compteur triphasé ;
- la figure 4a représente un schéma d'implantation des plots de connexion de l'interface de connexion de comptage pour un module socle d'un compteur modulaire mono- ou tri-phasé ;
- la figure 4b représente l'affectation des plots de connexion du schéma des plots de connexions de la figure 4a ;
- la figure 4c représente, à titre illustratif, l'aspect général d'un module de comptage, pour un compteur modulaire mono- ou tri-phasé ;
- la figure 5 représente, à titre illustratif, un schéma fonctionnel par schéma blocs du module d'appariement des fonctions du module socle et du module de comptage ;
- la figure 6a représente un schéma illustratif des ressources de détection de la violation des scellés et de l'accès à la vis de fixation du module de comptage ;
- la figure 6b représente, à titre illustratif, le mode opératoire d'un module de détection antifraude lors de la dépose sans autorisation du module de socle ;
- la figure 6c et la figure 6d, représentent un mode de mise en oeuvre préférentiel d'une ressource d'identification du module socle par le module de comptage, permettant d'empêcher le remplacement frauduleux du module de comptage appairé par un module de comptage tiers.

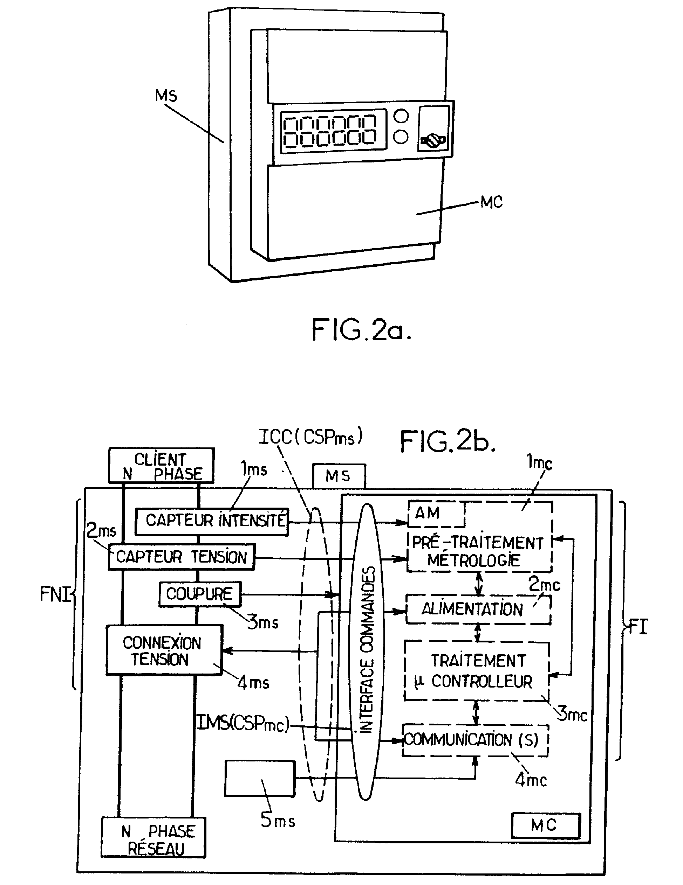

Une description plus détaillée du compteur modulaire de consommation d'effluent par un abonné client, conforme à l'objet de la présente invention, sera maintenant donnée en liaison avec les figures 2a et suivantes.

En référence à la figure 2a précitée, on indique que le compteur modulaire objet de l'invention comporte au moins un module socle, noté MS, permettant d'adapter la configuration de connexion du point de livraison d'effluent, afin d'assurer la liaison des canalisations du réseau de distribution d'effluent et les canalisations d'alimentation de l'installation d'abonné.

Ainsi qu'on l'a en outre représenté en figure 2b, le module socle MS est équipé d'une interface de connexion de comptage, notée ICC.

En outre, le compteur modulaire objet de l'invention comprend un module de comptage, noté MC, équipé d'une interface de connexion au module socle, MS, l'interface de connexion précitée étant notée IMS sur la figure 2b.

On comprend, en particulier, que la connexion du module de comptage MC au module socle MS est effectuée par l'intermédiaire de l'interface de connexion de comptage précitée ICC équipant le module socle MS.

Selon une autre caractéristique particulièrement avantageuse du compteur modulaire de consommation d'effluent objet de l'invention, l'ensemble des composants électriques exécutant les fonctions non intelligentes noté FNI à caractère permanent est installé dans le module socle MS et l'ensemble des composants électroniques exécutant des fonctions intelligentes noté FI à caractère évolutif est installé dans le module de comptage MC. Ainsi, en référence aux figures 2a et 2b, on comprend que le module socle MS permet d'adapter la configuration mécanique du point de la livraison d'énergie ou d'effluent à tout nouveau module de comptage.

Le module socle MS est indispensable pour adapter tous les cas de tableau de comptage envisageables. Il permet de faire la liaison entre les canalisations du réseau d'alimentation et les canalisations de distribution du client abonné.

Le module de comptage MC peut être au contraire équipé des fonctions intelligentes FI.

Ainsi, conformément à un objet de l'invention, les fonctionnalités non intelligentes et les moins vieillissantes sont intégrées dans le module socle alors que l'ensemble des fonctionnalités évolutives sont intégrées dans le module de comptage MC précité. Sachant que les composants électroniques vieillissent rapidement, le module socle n'en possède en pratique pas ou peu. Inversement, le module de comptage à caractéristiques modulaire est facilement interchangeable. Il possède en fait tous les composants électroniques passifs ou actifs du système de comptage.

En particulier, ainsi que représenté en figure 2b, les composants exécutant les fonctions à caractère permanent et donc les fonctions non intelligentes comprennent au moins les capteurs d'intensité notés 1ms, les capteurs de tension notés 2ms, les organes de coupure notés 3ms, les circuits de connexion de tension, notés 4ms, ainsi que les modules ou liens physiques de communication, notés 5ms, vers le client abonné et vers l'entité distributeur d'effluent par exemple. L'ensemble des composants précités permet d'exécuter les fonctions non intelligentes FNI précédemment citées.

Au contraire, ainsi que représenté également en figure 2b, les composants exécutant les fonctions à caractère évolutif comprennent au moins les composants de prétraitement métrologique notés 1mc, les composants d'alimentation électronique 2mc, les composants de traitement par microcontrôleur ou microprocesseur noté 3mc, et les composants de communication en réseau noté 4mc.

En outre, ainsi que représenté en figure 2b, pour l'effluent tel que le courant électrique, le module socle MS peut être adapté pour assurer la liaison au tableau de comptage. L'interface de connexion de comptage ICC est alors constituée par un connecteur électrique spécifique, noté CSPms et l'interface de connexion au module socle IMS équipant le module de comptage MC est de même constituée par un autre connecteur spécifique noté CSPmc. Le module de comptage MC est connecté au module socle MS par simple enfichage du connecteur CSPmc dans le connecteur électrique spécifique CSPms.

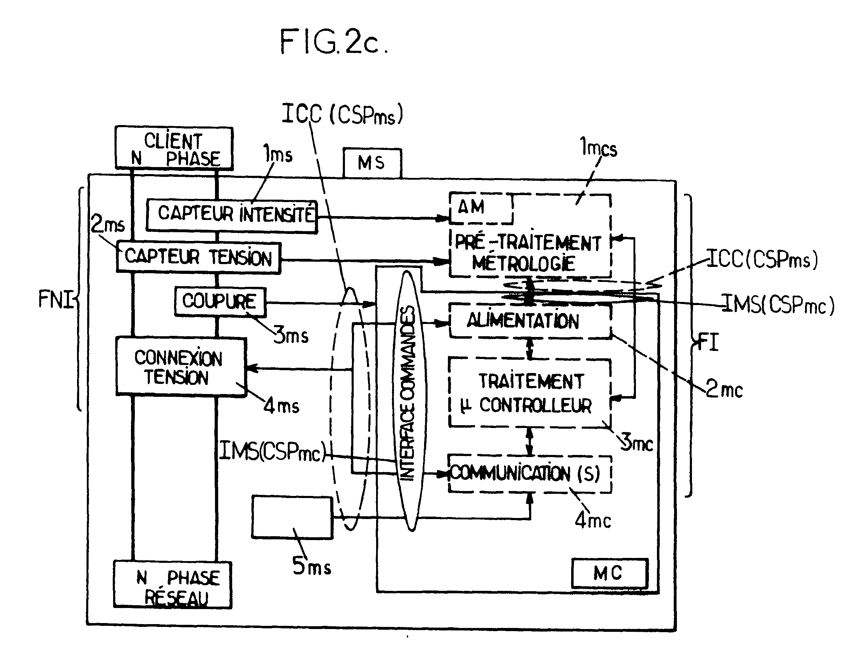

Selon un exemple de compteur modulaire de consommation d'effluent de l'invention, tel que représenté en figure 2c, le composant de prétraitement métrologique noté 1mc tel que représenté en figure 2a peut au contraire être intégré au module socle MS pour des raisons d'opportunité de fabrication et de mise en oeuvre du compteur modulaire de consommation d'effluent objet de l'invention.

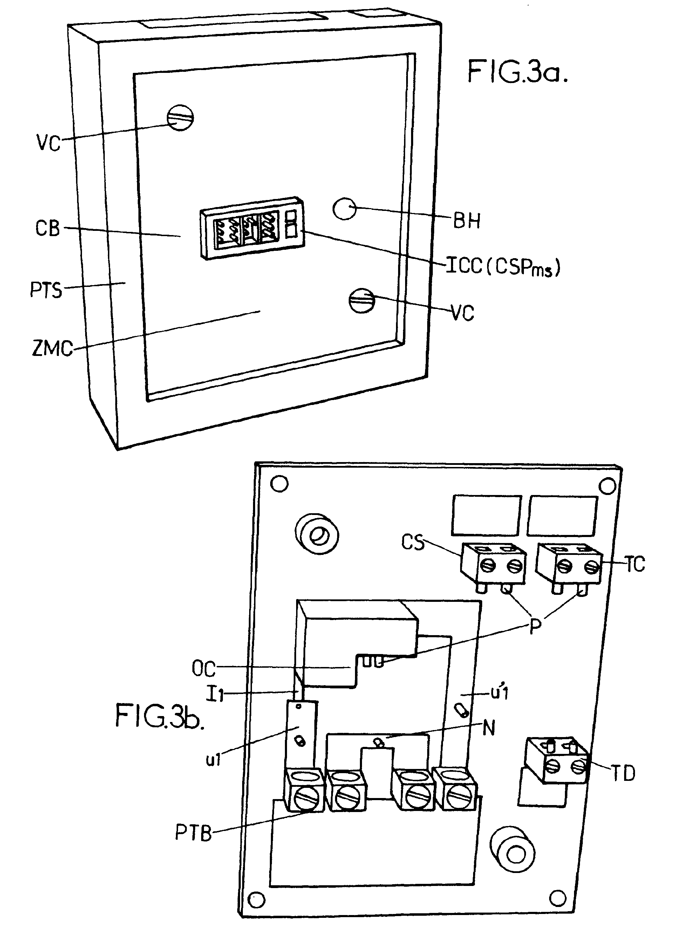

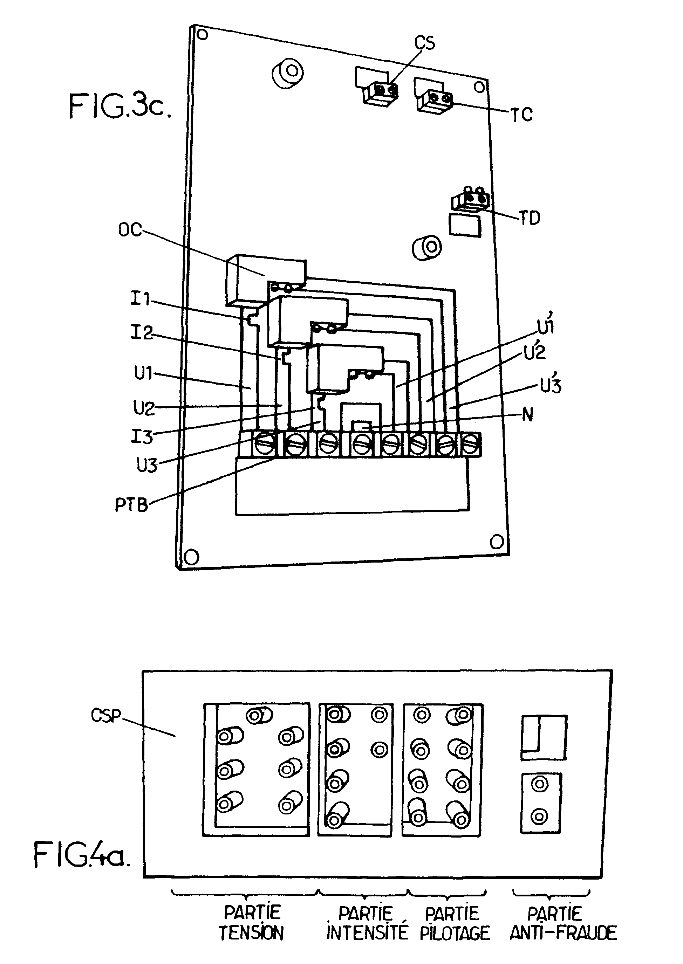

Une description du module socle MS sera maintenant donnée en liaison avec les figures 3a, 3b et 3c.

Ainsi qu'on l'a représenté sur la figure 3a, le module socle MS est constitué essentiellement de deux éléments :
-- une platine de fixation portant les fonctionnalités et composants du module socle, notée PTS, et
-- un cache borne noté CB recouvrant sensiblement la platine de fixation.

Le module socle MS représenté en figure 3a comporte ainsi sur le cache borne CB une zone réservée pour le module de comptage notée ZMC, des vis de fixation du cache borne notées VC, un trou taraudé pour la fixation du module de comptage noté BH et, bien entendu, le connecteur spécialisé CSPms constituant l'interface de connexion de comptage notée ICC. Il comporte en outre au niveau du cache borne BC un trou taraudé pour la fixation du module de comptage lorsque ce dernier a été placé par enfichage sur le connecteur spécialisé CSPms.

D'une manière générale, le module socle MS, tel que représenté en figure 3a est sensiblement identique pour le comptage d'énergie électrique délivrée par courant mono ou triphasé. On comprend, en particulier, que la différence engendrée par la fourniture d'énergie en courant mono ou triphasé résulte en une simple différence de dimensionnement de la platine PTS.

On comprend, en particulier, que le compteur modulaire de consommation d'effluent objet de l'invention, lorsque l'effluent est de l'énergie électrique, est particulièrement avantageux car il permet d'harmoniser en fait tous les points de livraison. En effet sur le territoire français par exemple on comptabilise environ 80 % de comptage en courant monophasé et 20 % de comptage en courant triphasé. Cette diversité de matériels entraîne une multiplication des outils des matériels et des procédures qui augmentent les coûts de maintenance pour le distributeur d'énergie électrique.

Le compteur modulaire de consommation d'effluent objet de l'invention comporte au contraire un module socle pour les branchements monophasés et un module socle pour les branchements triphasés identiques, à la différence dimensionnelle près, vue précédemment, alors que l'interface entre le module de comptage et les modules socle précités est sensiblement identique, car utilisant le même connecteur spécialisé.

Ainsi le module de comptage constituant la partie intelligente et mettant en oeuvre les fonctions intelligentes FI peut être raccordé sur les deux socles. Ainsi le compteur modulaire objet de l'invention permet de gérer sur tout un territoire un seul type de compteur, quel que soit le type de branchements mono- ou triphasé. Des détails d'exécution du module socle MS seront maintenant donnés en liaison avec les figures 3b et 3c.

D'une manière générale, on indique que la platine de fixation notée PTS comprend :
-- la platine de fixation proprement dite constituée en matériau synthétique ;
-- des bornes de raccordement des câbles de puissance ;
-- des bornes de raccordement pour les interfaces telles que contact sec (relais), interfaces distributeur interfaces clients ;
-- des capteurs de tension et de courants ;
-- l'organe de coupures ;
-- un connecteur permettant d'exécuter l'interface avec le module de comptage ainsi que précédemment mentionnées. Le cache borne CB recouvre en quasi-totalité la platine de fixation PTS. Il est de préférence constitué en matériau synthétique et équipé des deux vis de fixation VC permettant la liaison mécanique avec la platine.

Le cache borne CB est équipé d'une ouverture permettant au connecteur spécifique CSPms d'être visible lorsque le cache borne est en place. Une trappe peut être ménagée au-dessus du cache borne CB afin de permettre au client abonné d'avoir un accès aux bornes d'un contact sec et à l'interface client, sans avoir à déposer le cache borne.

Un mode d'implantation préférentielle des composants exécutant les fonctions du module socle MS pour un branchement monophasé sera maintenant décrit en liaison avec la figure 3b, représenté lorsque le cache borne CB est ôté.

Les picots p représentés sur le schéma de la figure 3b associés à chacun des composants indiquent les points de raccordement électrique avec le connecteur spécialisé CSPms en face avant du module socle MS, tel que représenté en figure 3a. Dans le but de ne pas surcharger le dessin de la figure 3b, le connecteur spécialisé précité n'est pas représenté.

En liaison avec la figure 3b précitée, les références désignent :
-- I1 : capteur d'intensité sur la phase 1, 2 contacts ;
-- U1 : prise de potentiel sur la phase 1, en amont, côté réseau de distribution, 1 contact ;
-- N : prise de potentiel de neutre, 1 contact ;
-- U'1 : prise de potentiel sur la phase 1, en aval, côté installation client, 1 contact ;
-- OC : organe de coupure, 2 contacts ;
-- CS : contact sec, 2 contacts ;
-- TC : interfaces de communication client, 2 contacts ;
-- TD : interfaces de communication distributeur, 2 contacts.

Sur la figure 3c, on a représenté une implantation analogue des composants pour un comptage triphasé.

Les mêmes références représentent les mêmes éléments que dans le cas de la figure 3b. I1 à I3 désignent les capteurs d'intensité sur les phases 1,2 et 3, U1 à U3 désignent les prises de potentiel sur les phases 1,2 et 3, en amont, U'1 à U'3 désignent les prises de potentiel sur les phases 1, 2 et 3 en aval.

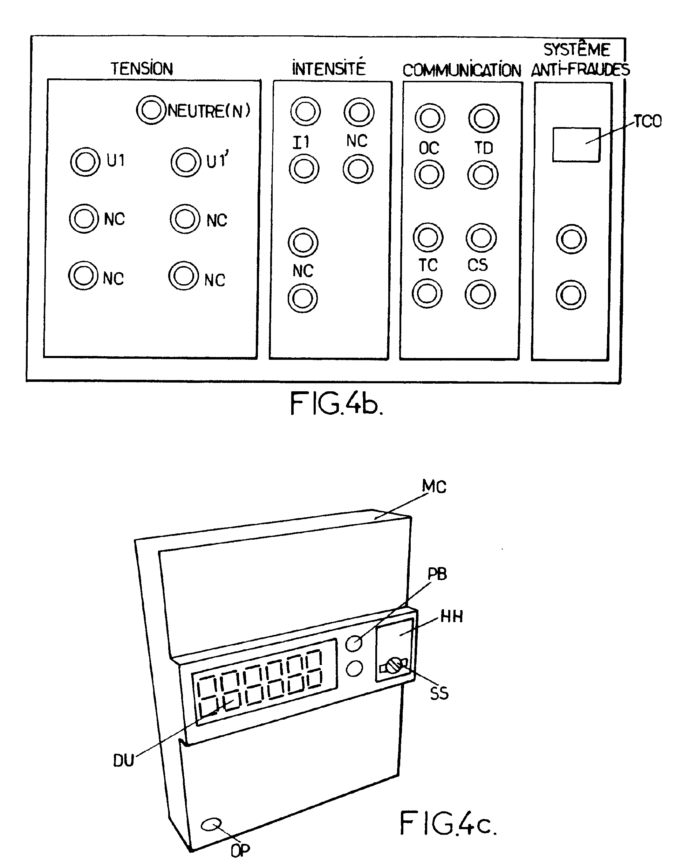

Une description plus détaillée du connecteur spécifique CSPms constitutif de l'interface de connexion et de comptage ICC équipant le module socle MS sera maintenant donnée en liaison avec les figures 4a et 4b.

En référence à la figure 4a, on indique que le connecteur spécifique CSPms précité comporte une structure matérielle sensiblement identique pour un comptage monophasé et pour un comptage triphasé.

En particulier, le compteur spécifique précité est divisé en plusieurs zones fonctionnelles telles que représentées au dessin, à savoir une zone ou partie tension, une zone ou partie intensité, une zone ou partie pilotage et une zone ou partie anti-fraude.

Les zones précitées comportent chacune un certain nombre de plots de connexion auxquels la fonction attribuée est décrite ci-après en référence à la figure 4b, pour le cas spécifique d'un comptage monophasé.

Sur la figure 4b, la zone ou partie tension comprend un plot de neutre, N, 2 plots supérieurs référencés U1 et U'1, relatifs à la connexion des prises de tension amont et aval précitées. Les 4 plots supplémentaires NC ne sont pas connectés en comptage monophasé.

La zone ou partie intensité comprend 2 plots de connexion notés I1 correspondant à la mesure d'intensité. Les autres couples de plots de connexion de la zone précitée sont non connectés NC en comptage monophasé.

La zone partie pilotage ou communication comprend 2 plots de commande d'organe de coupure notés OC, 2 plots d'interface de communication distributeur notés TD, 2 plots d'interface de communication client notés TC et 2 plots de connexion contact sec notés CS.

La zone système antifraude comprend une trappe de commande TCO permettant le passage d'un organe mécanique de commande anti fraude, lequel sera décrit ultérieurement dans la description. Il comporte en outre 2 plots de contact de commande anti fraude.

Pour un connecteur spécifique CSPms en comptage triphasé, on comprend que les plots non connectés, désignés NC sont affectés aux fonctions des autres phases 2 et 3.

Enfin, le module de comptage MC est représenté en figure 4c. Ce dernier possède sur la face arrière non représentée le connecteur CSPmc permettant d'effectuer de raccordement sur le connecteur spécifique CSPms équipant le module socle MS, pour un comptage monophasé ou triphasé.

Sur la face avant, telle que représentée en figure 4c, le module de comptage est avantageusement équipé d'une trappe d'accès à la vis de fixation du module de comptage MC au module socle MS. La trappe d'accès précitée est notée HH sur la figure 4c. La trappe précitée est fermée par une vis SS adaptée à la pose d'un scellé de type classique.

Le module de comptage est équipé sur sa face avant d'un afficheur à cristaux liquides noté DU. Des boutons poussoirs sont également prévus en face avant, notés BP, lesquels permettent à un utilisateur de sélectionner les données à afficher par l'afficheur DU.

En outre, en face avant une interface optique ou port de communication optique noté OP permet de configurer localement le module de comptage au moyen d'une interface de communication optique.

Lorsque le module de comptage MC a été mis en place, ce dernier détecte automatiquement s'il est branché sur un socle de comptage mono- ou triphasé par la mesure de la présence de tension entre la connexion de neutre et les différentes phases. Le fonctionnement du module de comptage est alors sélectionné en fonction de la présence de tension monophasée ou respectivement triphasée.

Le compteur modulaire de consommation d'effluent objet de la présente invention peut comporter également un module d'appariement des fonctions du module socle MS et du module de comptage MC.

Le module d'appariement permet d'exécuter, lors de la connexion du module de comptage MC au module socle MS, au moins une fonction de calibrage des valeurs d'intensité et de tension délivrées par le module socle et respectivement souscrites, appelées et mesurées par le module de comptage MC en fonction des paramètres d'installation de l'abonné client.

On comprend, en particulier, dans un exemple non limitatif, que le module d'appariement précité est de préférence implanté dans le module de prétraitement métrologique désigné 1mc sur la figure 2b, respectivement 1mcs sur la figure 2c.

Dans un exemple non limitatif, le module d'appariement AM permet de manière particulièrement avantageuse l'exécution d'une fonction d'authentification du module de comptage MC à partir de paramètres d'authentification relatifs au distributeur d'effluent, à l'installation de l'abonné client, à la validité de l'exécution de l'installation et/ou du changement ou remplacement du module de comptage MC.

À cet effet, le module d'appariement AM inclut avantageusement au moins un gabarit précis des capteurs et composants inclus dans le module socle MS.

Enfin le module d'appariement inclut avantageusement une mémoire permettant la mémorisation d'une pluralité de paramètres tels que les paramètres de correction de l'ensemble des composants inclus dans le module socle MS, d'authentification de l'installation d'abonné client et/ou de l'entité distributeur d'effluent.

Dans un exemple non limitatif, le module d'appariement inclut en outre un programme d'auto calibration des composants du module socle MS, ce programme étant directement exécutable par le microcontrôleur ou par un microprocesseur tel que décrit précédemment dans la description.

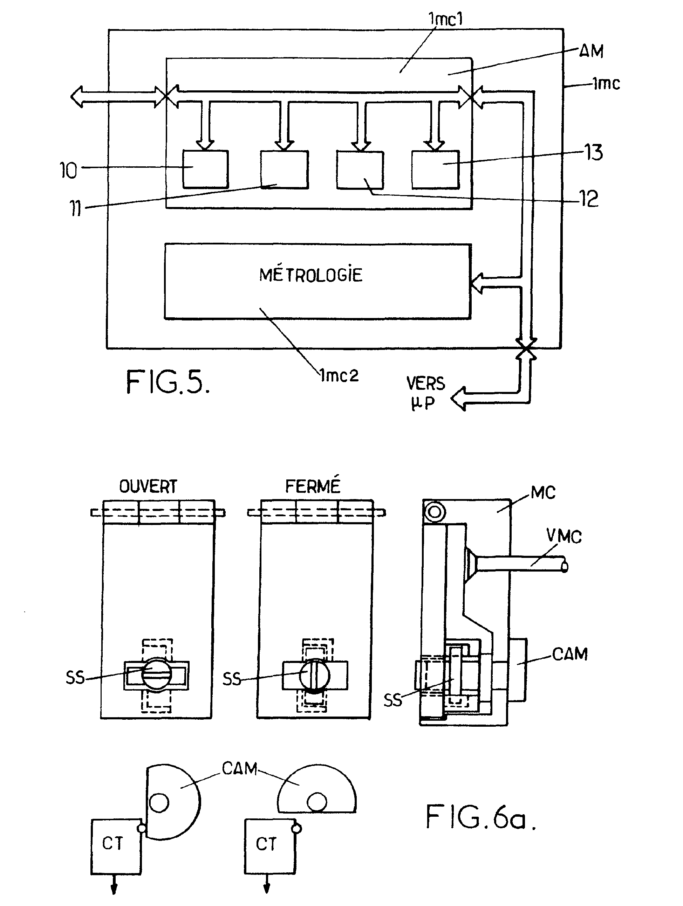

Une architecture plus détaillée du module d'appariement AM sera maintenant décrite en liaison avec la figure 5. L'architecture précitée est décrite dans le cas préférentiel où le module d'appariement AM est implanté dans le module de prétraitement métrologique noté 1mc sur la figure 2b.

Dans cette hypothèse, le module d'appariement AM est noté 1mc1 et comporte un module 10 de calibrage, un module 11 d'authentification, une mémoire morte par exemple de type ROM et une mémoire programmable telle qu'une mémoire de type EEPROM reprogrammable électriquement par exemple.

Le module 10 permet l'exécution de la fonction de calibrage des valeurs d'intensité et de tension délivrées par le module socle par l'intermédiaire du microprocesseur ou microcontrôleur référencé 3mc sur la figure 2b.

Le module 11 permet l'exécution de l'opération d'authentification du module de comptage MC à partir des paramètres d'authentification relatifs au distributeur d'effluent, à l'installation de l'abonné client, à la validité de l'exécution de l'installation et ou du changement ou remplacement du module de comptage. On comprend, en particulier, que l'opération d'authentification précitée est exécutée par le microprocesseur précédemment décrit. Elle peut consister en une opération de vérification de signatures intégrant l'ensemble des paramètres précités comme paramètres.

Dans un exemple non limitatif, on indique que l'exécution du programme d'auto calibration est rendue conditionnelle à une authentification réussie du module de comptage MC vis-à-vis du module socle MS ou réciproquement. On comprend en particulier que la notion d'authentification réussie du module de comptage vis-à-vis du module socle réciproquement du module socle vis-à-vis du module de comptage peut être effectuée par comparaison de paramètres mémorisés soit dans la mémoire programmable non volatile 13 soit dans la mémoire permanente 12 de type ROM par exemple. Le gabarit précis des capteurs et composants inclus dans le module socle MS peut également être mémorisé dans la mémoire ROM précitée en raison de leur caractère permanent.

Au contraire les paramètres relatifs à l'installation de l'abonné client, à la validité de l'exécution de l'installation et/ou du changement ou de remplacement du module de comptage peuvent être mémorisés dans la mémoire programmable non volatile 13 et actualisés en tant que de besoin par le distributeur d'effluent, cette opération pouvant bien entendu être exécutée à distance depuis un centre de gestion habilité. Ces opérations peuvent être effectuées lors d'un changement d'abonnement par exemple. L'opération d'actualisation peut être effectuée grâce à la connexion de chaque module de comptage et/ou module socle et du centre de gestion habilité en réseau dédié, réseau CPL, ou en réseau supportant d'autres architectures physiques.

Le compteur modulaire de consommation d'effluent objet de l'invention est également équipé d'un système anti fraude plus particulièrement destiné à la détection des fraudes.

D'une manière générale les fraudes les plus courantes concernent :
-- la violation des scellés de l'accès à la vis de fixation du module de comptage MC ;
-- la dépose du module de comptage MC en l'absence d'autorisation ou d'habilitation par le distributeur d'effluent ;
-- le remplacement du ou d'un module de comptage MC apparié sur un module socle par un module de comptage provenant d'un module socle différent, et donc non apparié.

La figure 6a représente à titre illustratif une ressource équipant le compteur modulaire objet de l'invention afin de permettre de détecter la violation du scellé apposé sur la vis à scellé SS et l'ouverture non autorisée de la trappe donnant accès à la vis de fixation VMC du module de comptage MC sur le module socle MS.

Ainsi que représenté sur la figure 6a, la vis à scellé notée SS permet de verrouiller l'ouverture de la trappe d'accès à la vis de fixation. Ce verrouillage s'effectue par exemple en un quart de tour. Une came notée CAM est actionnée directement par la vis précitée commandée en rotation et permet à un contacteur noté CT de connaître la position effective de la vis à scellé SS.

Le changement de position de la fermeture à l'ouverture est alors autorisé seulement si le module de comptage MC a reçu préalablement une autorisation pour une telle action, autorisation transmise soit par le port de communication optique OP, soit en réseau par le centre de gestion du distributeur d'effluent par exemple.

En particulier, si avant d'actionner la vis de fixation à scellé de la trappe et que le module de comptage MC n'a pas reçu l'information d'une telle action, il procède alors à la détection du changement de position de la vis à scellé SS par l'intermédiaire de la came CAM et du contacteur CT et procède alors à la commande à l'ouverture de l'organe de coupure OC présent dans le module socle. Un message peut alors être affiché sur l'afficheur DU « violation du scellé -- veuillez contacter votre conseiller clientèle ». L'installation électrique du client dont l'action est alors présumée frauduleuse n'est plus alimentée.

Au contraire lorsque le module de comptage MC a reçu l'instruction d'accès à la vis à scellé SS et à la vis de fixation du module de comptage MC par l'intermédiaire du port de communication locale optique ou par l'intermédiaire du réseau, le module de comptage inhibe l'ouverture de l'organe de coupure lors du changement de position de la vis à scellé. Ceci est le cas lors d'une action de maintenance sur le module de comptage MC par exemple. Le module de comptage MC peut ainsi être changé sans suspendre la fourniture d'énergie électrique au client concerné.

En outre, lorsque le module de comptage a reçu une information d'autorisation de changement de position de la vis à scellé, il peut alors procéder à une autorisation de ce changement de position pendant une durée déterminée de l'ordre d'une minute par exemple. Au-delà d'une telle durée, tout changement de position entraîne automatiquement l'ouverture de l'organe de coupure OC présent dans le module socle MS.

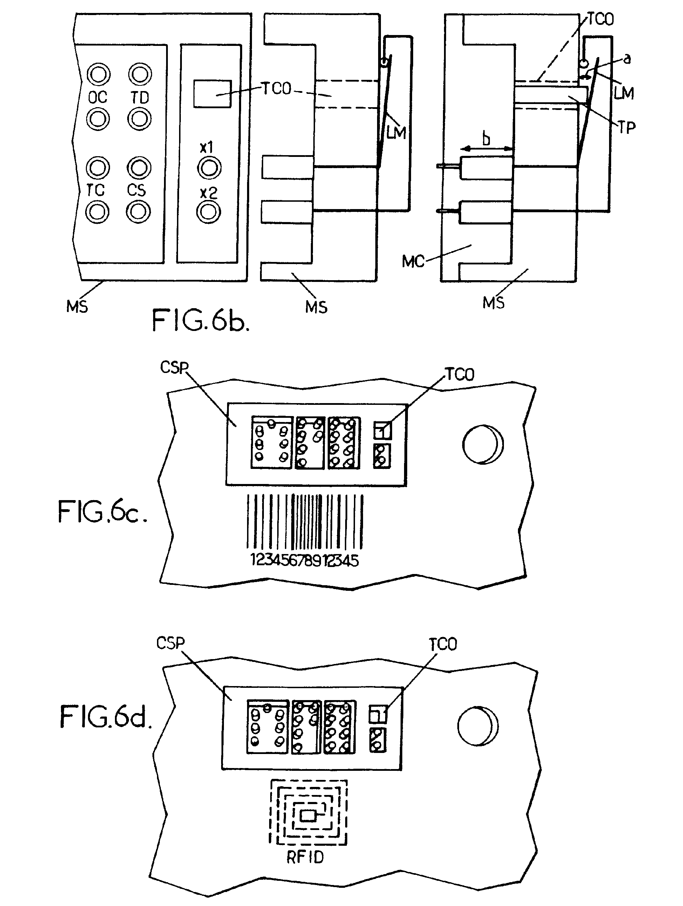

La figure 6b représente le mode opératoire d'un dispositif de détection d'une dépose du module de comptage en l'absence d'autorisation.

D'une manière générale le perçage de la trappe d'accès à la vis de fixation sans avoir à manoeuvrer la vis à scellé SS ne peut être totalement exclu. Le module de comptage, dans cette hypothèse, peut alors être déconnecté et l'alimentation en énergie électrique du client abonné maintenu de manière frauduleuse.

Pour éviter ce type de fraude, un dispositif de détection de fraude correspondante est prévu au niveau du connecteur spécifique CSPms et basé sur le même principe que celui relatif à la vis de fixation.

Ainsi que représenté sur la figure 6b, le connecteur spécialisé CSPmc est alors constitué d'une partie mâle placée au dos du module de comptage et d'une partie femelle CSPms placée sur le module socle MS.

Sur la figure 6b on a représenté en vue de face la zone anti fraude du connecteur spécialisé CSPms et comportant la trappe le commande TCO et les broches ou plots de connexion x1, x2 permettant de connaître la position d'un contact anti fraude.

La figure 6b comporte également une vue en coupe de la partie femelle du connecteur spécifique CSPms, en l'absence de la partie mâle, et de la partie femelle précitée en présence de la partie mâle correspondante.

Sur la partie femelle précitée représentée en figure 6b est installé un dispositif permettant de détecter le début d'une manoeuvre de dépose du module de comptage MC. Ce dispositif est constitué d'une lame métallique LM à contact à 2 positions :
-- au repos aucun module de comptage MC n'est raccordé sur le module socle MS ainsi que représenté pour la partie femelle sans partie mâle; en position opérationnelle ou tendue, un module de comptage MC est enfiché sur le module socle MS.

Le module de comptage MC est pourvu d'une tige plastique notée TP placée sur la partie mâle du module de comptage. Lors de l'enfichage du module de comptage MC, la tige plastique TP ouvre à l'ouverture le contact de la lame métallique LM, le circuit de détection de position de lame étant de ce fait normalement ouvert. La position effective de la lame métallique elle-même est alors disponible au niveau des deux broches du connecteur permettant de connaître la position de la lame métallique et notées x1 et x2 sur la figure 6b.

Dans l'hypothèse d'une dépose frauduleuse du module de comptage MC, le changement d'état par passage de l'état d'ouverture à l'état de fermeture du contact de la lame métallique LM est exécuté avant la déconnexion complète des broches du connecteur spécialisé CSPmc.

L'organe de coupure OC dans le module socle MS est alors actionné si le module le comptage n'a pas reçu une autorisation soit via le port de communication locale OP, soit par l'intermédiaire du réseau par exemple.

Le module de comptage MC est en mesure de détecter un début de manoeuvre de dépose frauduleuse de ce dernier. Dans ce but, la distance d'ouverture de la lame métallique LM, c'est-à-dire sensiblement la distance a de dépassement de la tige plastique TP au-delà de la trappe de commande TCO telle que représenté en figure 6b, est largement inférieure à la longueur d'enfichage des plots de contact désignée b des plots x1 et x2, permettant de reconnaître la position de la lame métallique LM.

Le module de comptage MC est alors en mesure de commander l'ouverture de l'organe de coupure OC avant déconnexion complète.

Enfin le compteur modulaire objet de l'invention, en particulier les ressources anti fraude de ce dernier, inclut un dispositif de détection d'une substitution du module de comptage non autorisée.

Le dispositif précité permet d'éviter qu'un abonné client ou un tiers n'échange son module de comptage apparié par un autre module de comptage non apparié.

De manière générale un tel dispositif met en oeuvre une identification du module socle MS par un module de comptage MC dédié ou habilité par le distributeur d'effluent.

En outre, et selon une caractéristique remarquable du compteur modulaire objet de l'invention, l'identification précitée peut être rendue réciproque pour exécuter conjointement une identification du module de comptage habilité MC par le module socle MS. Un tel processus peut, en particulier, être effectué dans le cadre du processus d'authentification précédemment décrit dans la description, notamment, de manière non limitative, dans l'exemple de la figure 2b ou 2c où le module d'authentification AM et correspondant au module 1mc ou 1mcs représenté à figure 5 permet l'authentification réciproque précitée.

Dans un exemple non limitatif, le processus d'identification précité peut être exécuté à partir de la lecture d'un code à barres tel que représenté en figure 6c ou d'une puce RFID pour (Radio Frequency IDentification) ainsi que représenté en figure 6d.

Le module de comptage peut alors être programmé pour lire en permanence soit le code à barres soit la puce RFID lesquels peuvent alors être avantageusement placés au voisinage du connecteur spécifique CSPms sur le cache borne CB.

Le code à barres précité peut être gravé au laser dans la matière synthétique pour encoder un numéro spécifique. Un tel marquage est indélébile. Le module de comptage MC est équipé sur la face en vis-à-vis du cache borne CB d'un lecteur de codes à barres et après enfichage lit à fréquence paramétrable et à chaque mise sous tension le numéro encodé précité.

Il en va de même pour la puce RFID représentée en figure 6d, laquelle peut être intégrée dans la matière du cache borne CB. La puce précitée n'est pas visible et comporte un numéro unique encodé. Dans cette solution le lecteur de code à barres est remplacé par un lecteur de puce RFID sur la face en vis-à-vis du cache borne.

On comprend alors que la valeur lue de numéro encodé peut être comparée dans le module de comptage MC ou en particulier dans le module d'appariement AM, par l'intermédiaire du microprocesseur, à toute valeur mémorisée soit dans la mémoire permanente ROM 12, soit dans la mémoire programmable 13 sous l'autorité du distributeur d'effluent.

Le compteur modulaire objet de l'invention présente une architecture d'une grande originalité, tant du point de vue de sa structure matérielle que de son agencement fonctionnel associé à cette dernière. L'architecture précitée a permis d'établir que le temps effectif de remplacement du module de comptage par un personnel habilité peut être ramené à moins de cinq minutes au lieu d'une durée de l'ordre de 30 minutes actuellement, ce qui, pour un taux de panne de 0,4 % par an les compteurs électroniques installés en France, permet d'évaluer un gain annuel sur la main-d'oeuvre de la maintenance comprise entre 3 et 5 millions d'euros.

L'architecture précitée est en outre remarquable en ce qu'elle permet de supprimer les tentatives de fraudes essentielles précédemment décrites.

L'architecture précitée est remarquable en ce qu'elle permet le changement du compteur sans couper l'installation et la distribution d'électricité aux clients abonnés, tout en améliorant le niveau de sécurité, la suspension automatique de la fourniture en énergie électrique lorsque le scellé de la vis à scellé est retirée sans autorisation, cette autorisation pouvant être programmée soit localement, soit à distance à partir d'un centre serveur géré par le distributeur d'effluent, la suspension de la fourniture en énergie électrique lorsque le module de comptage est déposé sans autorisation, la suspension de la fourniture en énergie électrique lorsque le module de comptage est échangé avec un autre module de comptage non apparié, sans autorisation.

Enfin l'architecture précitée est également remarquable en ce qu'elle permet d'améliorer le déploiement, l'exploitation et la maintenance du parc de compteurs en harmonisant tous les raccordements électriques ou de distribution d'effluent chez les clients abonnés tout en garantissant un haut niveau de protection et en assurant une gestion des stocks des compteurs.

## Revendications

1. Compteur modulaire de consommation d'effluent par un abonné client, **caractérisé en ce qu'**il comprend au moins :
- un module socle (MS) permettant d'adapter la configuration de connexion du point de livraison d'effluent, pour assurer la liaison des canalisations du réseau de distribution d'effluent et les canalisations d'alimentation de l'installation d'abonné, ledit module socle (MS) étant équipé d'une interface de connexion de comptage (ICC) et comprenant au moins un organe de coupure (OC);
- un module de comptage (MC) installé par enfichage sur ledit module socle et équipé d'une interface de connexion (IMS) audit module socle (MS), par l'intermédiaire de ladite interface de connexion de comptage (ICC) ;
- une vis de fixation (VMC) du module de comptage sur le module socle ;
dans lequel ledit module de comptage comporte en outre des ressources anti-fraude comportant au moins une vis à scellé (SS) d'accès à la vis de fixation et des moyens de détection d'un accès non autorisé à ladite vis de fixation à scellé, permettant de commander, dans ledit module socle, ledit au moins un organes de coupure ;
dans lequel l'ensemble des composants électriques exécutant les fonctions non intelligentes (FNI) à caractère permanent est installé dans ledit module socle (MS) et ce que l'ensemble des composants électroniques exécutant des fonctions intelligentes (FI) à caractère évolutif est installé dans ledit module de comptage (MC).

2. Compteur selon la revendication 1, **caractérisé en ce que** lesdites ressources anti-fraude comportent en outre des moyens de détection (LM) d'une dépose du module de comptage non autorisée.

3. Compteur selon l'une des revendications 1 ou 2, **caractérisé en ce que** lesdites ressources anti-fraude incluent en outre des moyens de détection d'une substitution du module de comptage non autorisée.

## Claims

1. Modular meter for flow consumption by a subscribing customer, **characterized in that** it includes at least:
a base module (MS) allowing the connection configuration of the flow delivery point to be adapted, to provide the connection of the flow distribution lines and the supply lines of the subscriber installation, said base module (MS) being equipped with a metering connection interface (ICC) and comprising at least one cut-off unit (OC);
a metering module (MC) installed by plugging it into said base module and equipped with a connection interface (IMS) for connecting to said base module (MS) via said metering connection interface (ICC); and
a fixing screw (VMC) of said metering module on said base module;
wherein the modular meter further comprises antifraud resources comprising at least one sealed screw (SS) for accessing the fixing screw and means for detecting an unauthorized access to said sealed fixing screw, allowing the control, in said base module, of said at least one cut-off unit;
wherein all of the electrical components performing non-intelligent functions (FNI) of a permanent nature are installed in said base module (MS), and all of the electronic components performing intelligent functions (FI) of a changeable nature are installed in said metering module (MC).

2. Meter as claimed in claim 1, **characterized in that** said antifraud resources further comprise means (LM) for detecting an unauthorized removal of the metering module.

3. Meter as claimed in one of claims 1 or 2, **characterized in that** said antifraud resources further include means for detecting an unauthorized substitution of the metering module.

## Patentansprüche

1. Modularer Zähler eines Flussverbrauchs durch einen Abnehmerkunden, **dadurch gekennzeichnet, dass** er zumindest das Folgende umfasst:
- ein Sockelmodul (MS), das die Anpassung eines Anschlusses des Flusslieferpunktes gestattet, um die Verbindung von Leitungen des Flussverteilungsnetzes und Leitungen zur Speisung der Installation des Abnehmers sicherzustellen, wobei das Sockelmodul mit einer Zähleranschlussschnittstelle (ICC) ausgestattet ist und zumindest ein Netzabschaltorgan (OC) umfasst;
- ein Zählmodul (MC), das durch Stecken auf das Sockelmodul installiert ist und das mit einer Schnittstelle (IMS) zum Anschluss an das Sockelmodul (MS), mittels der Zähleranschlussschnittstelle (ICC), ausgestattet ist;
- eine Schraube (VMC) zum Fixieren des Zählmoduls auf dem Sockelmodul;
wobei das Zählmodul unter anderem Anti-Betrugs-Mittel aufweist, die zumindest eine versiegelte Schraube (SS) für den Zugang zur Fixierungsschraube und Mittel zur Detektion eines nicht autorisierten Zugangs zur versiegelten Fixierungsschraube aufweisen, welche es gestatten, in dem Sockelmodul das mindestens eine Netzabschaltorgan zu steuern;
wobei die Gesamtheit der elektrischen Komponenten, die nicht-intelligente Funktionen (FNI) permanenten Charakters ausführen, in dem Sockelmodul (MS) installiert ist und dass die Gesamtheit der elektrischen Komponenten, die intelligente Funktionen (FI) entwicklungsfähigen Charakters ausführen, in dem Zählmodul (MC) installiert ist.

2. Zähler gemäß Anspruch 1, **dadurch gekennzeichnet**, das die Anti-Betrugs-Mittel unter anderem Mittel zur Detektion (LM) eines nicht autorisierten Ausbaus des Zählmoduls umfassen.

3. Zähler gemäß Anspruch 1 oder 2, **dadurch gekennzeichnet**, das die Anti-Betrugs-Mittel unter anderem Mittel zur Detektion einer nicht autorisierten Ersetzung des Zählmoduls umfassen.
